# FASCICULE DE BREVET EUROPEEN

(11) **EP 1 192 665 B1**
(45) Date de publication et mention de la délivrance du brevet: **17.06.2009**
(21) Numéro de dépôt: 00949562.3
(22) Date de dépôt: 28.06.2000
(51) Int. Cl.: H01L 29/201, H01L 29/205, H01L 29/737, H01L 29/778

(54) **Transistor bipolaire III-V à hétérojonction**
Heteroübergangs-Bipolartransistor aus III-V Material
Heterojunction III-V bipolar transistor

(30) Priorité: 01.07.1999 FR 9908487
(43) Date de publication de la demande: 03.04.2002
(73) Titulaire: PICOGIGA INTERNATIONAL, 38190 Bernin (FR)
(72) Inventeur: NUYEN, Linh, T., F-75016 Paris (FR)
(74) Mandataire: Le Forestier, Eric
(86) Numéro de dépôt international: PCT/FR2000/001806
(87) Numéro de publication internationale: WO 2001/003194

(56) Documents cités:
- EP-A- 0 833 395
- US-A- 5 383 211
- US-A- 5 689 123
- PATENT ABSTRACTS OF JAPAN vol. 1999, no. 01, 29 janvier 1999 (1999-01-29) & JP 10 284506 A (FURUKAWA ELECTRIC CO LTD:THE), 23 octobre 1998 (1998-10-23)
- SOUKIASSIAN P ET AL: "ROOM-TEMPERATURE NITRIDATION OF GALLIUM ARSENIDE USING ALKALI METAL AND MOLECULAR NITROGEN" PHYSICAL REVIEW, B. CONDENSED MATTER,AMERICAN INSTITUTE OF PHYSICS. NEW YORK,US, vol. 42, no. 6, 15 août 1990 (1990-08-15), pages 3769-3772, XP000151568 ISSN: 0163-1829 cité dans la demande
- KONDOW M ET AL: "GAINNAS: A NOVEL MATERIAL FOR LONG-WAVELENGTH-RANGE LASER DIODES WITH EXCELLENT HIGH-TEMPERATURE PERFORMANCE" JAPANESE JOURNAL OF APPLIED PHYSICS,JP,PUBLICATION OFFICE JAPANESE JOURNAL OF APPLIED PHYSICS. TOKYO, vol. 35, no. 2B, 1 février 1996 (1996-02-01), pages 1273-1275, XP000701044 ISSN: 0021-4922 cité dans la demande
- HAN J ET AL: "GROWTH AND FABRICATION OF GAN/AIGAN HETEROJUNCTION BIPOLAR TRANSISTOR" APPLIED PHYSICS LETTERS,US,AMERICAN INSTITUTE OF PHYSICS. NEW YORK, vol. 74, no. 18, 3 mai 1999 (1999-05-03), pages 2702-2704, XP000823896 ISSN: 0003-6951

## Description

L'invention concerne les transistors à hétérojonction de la catégorie des transistors à effet de champ ou de celle des transistors bipolaires, utilisant des alliages de semi-conducteurs III-V.

Les semi-conducteurs III-V, dont le plus connu est l'arséniure de gallium GaAs, constituent une vaste famille faisant intervenir un ou plusieurs éléments de la colonne III et un ou plusieurs éléments de la colonne V du tableau de Mendeleïev. Ainsi on trouve :
- des composés binaires tels que GaAs ou InP ;
- des composés ternaires tels que AlGaAs ou GaInAs ou GaInP ;
- des composés quaternaires tels que GaInAsP ou AIGaSbAs.

Dans les alliages ternaires ou quaternaires, les éléments III se substituent entre eux et les éléments V aussi se substituent entre eux de telle manière que l'ensemble des éléments III et l'ensemble des éléments V soient à égale composition : par exemple, AlₓGa₁₋ₓAs ou GaₓIn₁₋ₓAs_{y}P_{1-y}. Pour ne pas alourdir le texte, on adoptera dans ce qui va suivre l'écriture simple AIGaAs ou GaInAsP. Quand cela sera nécessaire, on spécifiera la teneur en chacun des éléments. De plus, les différents éléments composant un alliage seront donnés dans l'ordre normalisé (du plus électropositif au moins électropositif), et non par teneur décroissantes.

L'intérêt de ces alliages ternaires ou quaternaires, voire quinquénaires, dans la réalisation de composants électroniques provient du fait que la substitution d'un élément III à un autre ou d'un élément V à un autre modifie les propriétés électroniques de l'alliage, par exemple la masse effective des électrons ou des trous, ou encore la largeur de la bande interdite. Et l'on met à profit ces modifications pour réaliser des hétérojonctions, c'est-à-dire des jonctions de deux matériaux de natures différentes, par exemple AIGaAs/GaAs ou GaInP/GaAs, etc.

Les lasers à semi-conducteurs AIGaAs/GaAs ou GaInP/AIGaInP ou In-GaAs/GaAs/GaInP sont des exemples bien connus de l'utilisation des hétérojonctions pour réaliser des lasers émettant des longueurs d'onde respectivement de 870, 670 et 980 nanomètres.

Les transistors à effet de champ dits de haute mobilité électronique ou *High Electron Mobility Transistor* (HEMT) faisant intervenir les hétérojonctions AIGaAs/GaAs ou AlGaAs/GalnAs/GaAs sont aussi très connus pour leurs performances améliorées par rapport aux transistors classiques GaAs sans hétérojonction.

On connait également du document JP-A-1 028 45 06 un transistor de type HEMT faisant intervenir une hétérojonction GaAs/GaAsN ou GaAs/InGaAsN, dans laquelle la substitution de l'arsenic par 10% d'azote permet de réduire la largeur de la bande interdite.

Les transistors bipolaires à hetérojonction (TBH ou HBT) de type AlGaAs/ GaAs ou GaInP/GaAs sont aussi connus pour leurs performances accrues par rapport aux transistors bipolaires GaAs sans héterojonction Malgré la souplesse de combinaison des alliages de semi-conducteurs III-V entre eux sous forme d'héterojonction, il existe cependant une limitation dans cette combinaison. En effet, on ne sait associer les différents matériaux entre eux que s'ils ont le même paramètre de maille cristalline ou sont de paramètres de maille très voisins, afin qu'il n'apparaisse pas de forte contrainte mécanique entre les différents matériaux. Une forte contrainte peut créer des dislocations naissant à l'interface matériaux et se propageant ensuite au sein d'un des deux matériaux, dégradant ainsi la qualité de ces matériaux et par la suite la qualité du composant électronique. Lorsqu'il on peut, par épitaxie, réaliser une hétérojonction sans faire apparaître de dislocations à son interface, car la contrainte mécanique créée est suffisamment faible pour que le matériau reste en régime de déformation élastique. Il est connu, que la déformation élastique est une fonction à la fois de l'écart de paramètres de réseau cristalline et de l'épaisseur de la couche contrainte. En deçà d'une certaine épaisseur dite "épaisseur critique", la couche reste en état de deformation élastique donc sans dislocation, et au-delà de l'épaisseur critique les contraintes se relâchent par apparition de dislocations.

Beaucoup de composants électroniques utilisent cette possibilité de contrainte élastique pour pouvoir disposer d'hétérojonctions de caractéristiques électroniques intéressantes. Par exemple, on réalise des hétéroques électroniques intéressantes. Par exemple, on réalise des des hétérojonction AlGaAs/GalnAs où la teneur en indium peut atteindre 25% créant ainsi un désaccord de paramètre approchant 2% imposant ainsi une épaisseur critique de l'ordre de 10 nanomètres.

Ce matériau contraint GalnGAs présente par rapport au matériau non contraint GaAs des avantages pour réaliser des transistors HEMT amélioration de la mobilité électronique, discontinuité de bande de conduction à l'interface de l'hétérojonction avantageusement plus importante. Ces transistors HEMT utilisant le matériau à faible bande interdite en état de contrainte élastique sont appelés "HEMT pseudomorphiques". Les HEMT pseudomorphiques sont très utilisés en amplification faible bruit comme en amplification de puissance.

Les transistors TBH utilisent peu cet état pseudomorphique, car la base du transistor TBH est généralement de l'ordre de 100 nanomètres, donc supérieure à l'épaisseur critique des matériaux en désaccord de maille et susceptibles de présenter des caractéristiques électroniques intéressantes. Ainsi, on ne connaît pas de produits industriels TBH pseudomorphiques.

D'autre part, du fait que les hétérojonctions sont généralement réalisées par épitaxie sur un substrat, c'est le substrat qui impose le paramètre de maille. Pour des raisons pratiques, les substrats sont des composés binaires, dont le plus développé au point de vue industriel est GaAs. Vient ensuite InP qui est difficile à fabriquer donc cher et qui, de plus, est fragile et cassant. Malgré ce handicap, InP est souvent utilisé car il offre la possibilité de réaliser des alliages comme GaInAs ou encore GaInAsP à très forte teneur en indium, allant jusqu'à 60 %. Ces alliages présentent des propriétés électroniques intéressantes, telles que la faible bande interdite allant de 0,6 à 1 eV.

Ainsi, dans l'état de l'art actuel, les transistors HEMT les plus utilisés peuvent être classés en deux catégories. La première catégorie utilise un substrat GaAs et des arséniures comme matériau à petite bande interdite : GaAs pour les HEMT non pseudomorphiques et GaInAs pour les HEMT pseudomorphiques avec une teneur en indium allant jusqu'à 25 % environ. La deuxième catégorie utilise un substrat InP et des arséniures comme matériau à petite bande interdite : GaInAs à 52 % de teneur en indium pour les -HEMT non pseudomorphiques et jusqu'à 65 % environ pour les HEMT pseudomorphiques.

En ce qui concerne les TBH, ils peuvent, de la même manière, être classés dans l'état de l'art actuel en deux catégories : ceux sur substrat GaAs avec GaAs comme matériau à petite bande interdite, et ceux sur substrat InP avec GaInAs (52 % de teneur en indium) comme matériau à petite bande interdite. Comme rappelé plus haut, les TBH pseudomorphiques n'ont pas connu de développement industriel. Dans les HEMT tout comme dans les TBH, l'utilisation des arséniures comme matériau à faible bande interdite présente néanmoins des limitations.

Dans les HEMT, les limitations se présentent comme suit : la principale caractéristique des HEMT est que l'association d'un matériau à grande bande interdite, généralement AlGaAs, à un matériau à petite bande interdite GaAs ou GaInAs permet d'avoir un gaz d'électrons bidimensionnel accumulé dans le matériau à petite bande interdite lorsque l'on dope le matériau à grande bande interdite. Ce transfert d'électrons du matériau à grande bande interdite vers le matériau à petite bande interdite est d'autant plus efficace que la discontinuité de la bande de conduction ΔEc est plus grande. Et une forte densité de gaz d'électrons bidimensionnel permet d'avoir un plus fort courant de drain du transistor, donc une amplification en puissance plus efficace. Or, dans le système arséniure avec la combinaison AIGaAs/GaAs ou AIGaAs/GaInAs, la discontinuité ΔEc est limitée. D'une part ΔEc, qui augmente avec la teneur en aluminium dans AIGaAs, ne peut pas dépasser une certaine valeur car au-delà de 22 % en aluminium, des défauts gênants dits "centres DX" apparaissant dans AIGaAs, et au-delà de 40 % le matériau AIGaAs présente une bande interdite indirecte. D'autre part, l'addition d'indium dans GaAs permet aussi d'augmenter ΔEc mais, comme rappelé plus haut, on ne peut guère dans la pratique, dépasser 25 %. Si bien qu'en pratique, le système AIGaAs/ GaInAs présente un maximum de ΔEc de l'ordre de 400 meV. Dans la catégorie des HEMT sur substrat InP où le matériau à grande bande interdite est AIInAs (53 % en indium) et celui à petite bande interdite est GaInAs (allant jusqu'à 65 % en indium), ΔEc ne dépasse pas 600 meV. Dans les TBH, les limitations se présentent comme suit : l'une des caractéristiques importantes du TBH est la tension V_{BE} qu'il faut appliquer à la base par rapport à l'émetteur pour que le collecteur reçoive le courant. Cette tension d'ouverture V_{BE} dépend fortement de la largeur de la bande interdite du matériau qui constitue la base. Par exemple, si le matériau de la base est GaAs, la tension d'ouverture V_{BE} est de l'ordre de 1 volt. Or l'une des applications la plus importante, en volume, des TBH est l'amplification de puissance dans les téléphones portables. Dans cette application, la tension d'alimentation est délivrée par une batterie et, pour des raisons, entre autres, de poids de cette batterie et de compatibilité de tension d'alimentation d'autres fonctions électroniques contenues dans le téléphone portable, la tension d'alimentation baisse au fur et à mesure que la technologie des semi-conducteurs progresse. En 1999, la tension la plus basse utilisée dans le téléphone de poche est de l'ordre de 3 volts, de sorte qu'avec un TBH dont la base est GaAs, une tension V_{BE} de 1 volt est tout à fait viable car il reste encore 2 volts efficaces. Mais lorsque la tension baisse vers 1,5 volt ou moins, une tension V_{BE} de 1 volt n'est plus acceptable. Il faut donc baisser la tension V_{BE} , autrement dit avoir la base du TBH constituée d'un matériau de bande interdite la plus petite possible. Une solution serait d'utiliser la deuxième catégorie de TBH en épitaxie sur InP, puisque la base constituée de GaInAs (52 % de teneur en indium) présente une bande interdite de l'ordre de 0,75 eV et pourrait conduire à une tension d'ouverture V_{BE} de l'ordre de 0,3 volt. Mais, comme rappelé plus haut, le substrat InP est cher et fragile. Donc le coût du composant sera trop élevé pour une application industrielle dont la réduction des coûts est un facteur majeur. Pour pallier ces inconvénients, la présente invention propose, essentiellement, d'utiliser des transistors à hétérojonction où le matériau à petite bande interdite est constitué par un alliage faisant intervenir à la fois au moins deux éléments V, l'arsenic et l'azote.

En effet, les composés III-V qui contiennent à la fois l'arsenic et l'azote ont la particularité de présenter une largeur de bande interdite plus faible que ceux qui n'en contiennent pas. En d'autres termes, la substitution d'une faible fraction d'arsenic par la même fraction d'azote fait baisser fortement la valeur de la bande interdite. Par exemple, le composé GaAsN à 4 % d'azote présente une largeur de bande interdite de 1 eV environ, alors que GaAs a pour largeur de bande interdite 1,42 eV. Cette propriété est particulière car, GaN étant un matériau à très grande bande interdite (3,4 eV), une règle simple, qui s'applique souvent dans les composés III-V, conduirait à donner au composé GaAsN une bande interdite plus élevée que GaAs. Cette propriété exceptionnelle a été signalée pour la première fois par M. Weyers et coll., Jpn. J. Appl. Phys., Vol. 31 (1992),-853, et les calculs théoriques confirment ces résultats expérimentaux (S. Sakai et coll., Jpn. J. Appl. Phys., Vol. 32 (1993), 4413). Le paramètre de maille des composés GaAsN suit la loi de Vegard, c'est-à-dire qu'il varie linéairement avec la teneur en azote. Donc, lorsque l'on dépose une couche mince de GaAsN par épitaxie sur un substrat GaAs, cette couche mince se trouve dans un état de contrainte, sachant que le paramètre de maille cristalline de GaN (0,45 nm) est plus faible que celui de GaAs (0,565 nm). Les travaux de Y. Qiu et coll. (Appl. Phys. Lett., 70 (24), 3242 (1997)) et ceux de E.V.K. Rao et coll. (Appl. Phys. Lett. 72 (12), 1409 (1998)) montrent que l'épaisseur critique des couches de GaAsN épitaxiées sur substrat GaAs est élevée et peut atteindre 100 nm pour une teneur en azote de l'ordre de quelques pour cents. Une telle épaisseur est tout à fait adaptée à la réalisation de transistors HEMT ou TBH.

Le paramètre de maille de GaAsN étant plus faible que celui de GaAs, on peut ajouter dans ce composé ternaire un élément chimique qui a pour effet d'augmenter son paramètre de maille. Ainsi, M. Kondow et coll. (Jpn. J. Appl. Phys., Vol. 35 (1996), 1273) propose d'additionner de l'indium pour former un composé quaternaire GaInAsN. Selon ces auteurs, ce composé quaternaire présente avec GaAs une grande discontinuité de bande de conduction ΔEc rendant son utilisation intéressante dans la réalisation de lasers à grande stabilité thermique.

Plus précisément, l'invention propose un transistor à hétérojonction, comprenant des matériaux semi-conducteurs III-V avec un matériau à grande bande interdite et un matériau à petite bande interdite, caractérisé en ce que : le matériau à petite bande interdite est un composé III-V contenant le gallium comme l'un des éléments III et à la fois l'arsenic et l'azote comme éléments V, la teneur en azote étant inférieure à 5 % environ, et le matériau à petite bande interdite comporte au moins un quatrième élément, III ou V, de manière que l'addition de ce quatrième élément permette d'ajuster la largeur de la bande interdite, la discontinuité de la bande de conduction ΔEc et la discontinuité de la bande de valence ΔEv de l'hétérojonction.

La grande valeur de ΔEc du composé GaInAsN peut être avantageusement utilisée pour la réalisation de transistors HEMT.

Dans ce cas, selon diverses caractéristiques subsidiaires avantageuses :
- le quatrième élément est l'indium, substitué au gallium en une fraction d'au plus 10 % environ de manière à procurer une bande interdite de 0,8 eV environ, une discontinuité de bande de conduction de 500 meV environ et une discontinuité de bande de conduction de 100 meV environ ;
- le matériau à grande bande interdite est soit AIGaAs de fraction molaire en aluminium de 25 % environ, de manière à procurer une discontinuité ΔEc de 800 meV environ et une discontinuité ΔEv de 300 meV environ, soit GaInP de fraction molaire en indium de 50 % environ, de manière à procurer une discontinuité ΔEc de 500 meV environ et une discontinuité ΔEv de 500 meV environ ;
- le quatrième élément est l'indium de fraction molaire 40 % environ, procurant ainsi un matériau à petite bande interdite en fort désaccord de maille par rapport au substrat GaAs, ce matériau à petite bande interdite étant épitaxié sur le substrat GaAs sans dislocations, et le matériau à grande bande interdite est AIInAs à 40 % d'indium environ, de manière à procurer une discontinuité ΔEc atteignant 1 eV environ ;
- le transistor est un transistor à effet de champ du type HEMT pseudomorphique, le matériau à petite bande interdite GaInAsN possédant une composition en indium et en azote telle que son paramètre de maille soit plus élevé que celui du substrat GaAs et qu'il soit dans un état de contrainte élastique, et le matériau à grande bande interdite est AIGaAs, de manière à procurer des discontinuités ΔEc et ΔEv de 900 meV environ.

L'invention s'applique également à la réalisation de transistors bipolaires à hétérojonction le matériau à faible bande interdite formant la base du transistor et le matériau à grande bande interdite formant l'émetteur du transistor.

Le quatrième élément peut alors être l'indium, substitué au gallium en une fraction d'au plus 10 % environ de manière à procurer une bande interdite de 0,8 à 1 eV environ, le matériau à grande bande interdite étant GaInP avec un teneur en indium de 50 % environ de manière à procurer une discontinuité ΔEv de 450 meV environ.

Le matériau formant la base du transistor présente de préférence une composition en azote qui est soit graduée, la teneur en azote étant nulle à l'interface de l'hétérojonction émetteur-base et allant croissant en allant vers la base, soit en marches d'escalier, la teneur en azote étant nulle à l'interface émetteur-base.

La faible valeur de la discontinuité de la bande de valence ΔEv du matériau GaInAsN par rapport à GaAs peut cependant constituer un handicap dans la réalisation de transistors TBH. La présente invention propose alors d'utiliser l'antimoine comme quatrième élément, substitué à l'arsenic en une fraction d'au plus 10 % environ, de manière à procurer une bande interdite de 0,8 à 1 eV environ.

Dans ce dernier cas, le matériau à grande bande interdite peut être GaAs, de manière à procurer une discontinuité ΔEc de 50 meV environ et une discontinuité ΔEv de 400 meV environ, ou bien GaInP avec une teneur en indium de 50 % environ, de manière à procurer une discontinuité ΔEc de 100 meV environ et une discontinuité ΔEv de 800 meV environ.

Le matériau à petite bande interdite peut être un composé quinquénaire GaInSbAsN.

On va maintenant décrire un exemple de mise en oeuvre de l'invention, en référence aux dessins annexés.
La figure 1 représente le schéma de bandes (de conduction et de valence) de l'hétérojonction GaAs/GaAsN.
La figure 2 représente le schéma de bandes de l'hétérojonction GaAs/ GaInAsN.
La figure 3 représente le schéma de bandes de l'hétérojonction GaInP/ GaAsN.
La figure 4 représente le schéma de bandes de l'hétérojonction GaInP/ GaInAsN.
La figure 5 représente le schéma de bandes de l'hétérojonction GaInP/ GaInAsN, dans la configuration où GaInP constitue l'émetteur d'un transistor TBH et GaInAsN en constitue la base.
La figure 6 représente la variation de la composition en azote dans la base en GaInAsN.
La figure 7 représente le schéma de bandes correspondant à l'hétérojonction décrite dans la figure 6.
La figure 8 représente la position des bandes de conduction et de valence des composés GaAs, GaSb et InAs et des alliages ternaires GaSbAs et GaInAs.
La figure 9 représente le schéma de bandes de l'hétérojonction GaAs/ GaSbAsN.
La figure 10 représente le schéma de bandes de l'hétérojonction GaInP/ GaSbAsN.

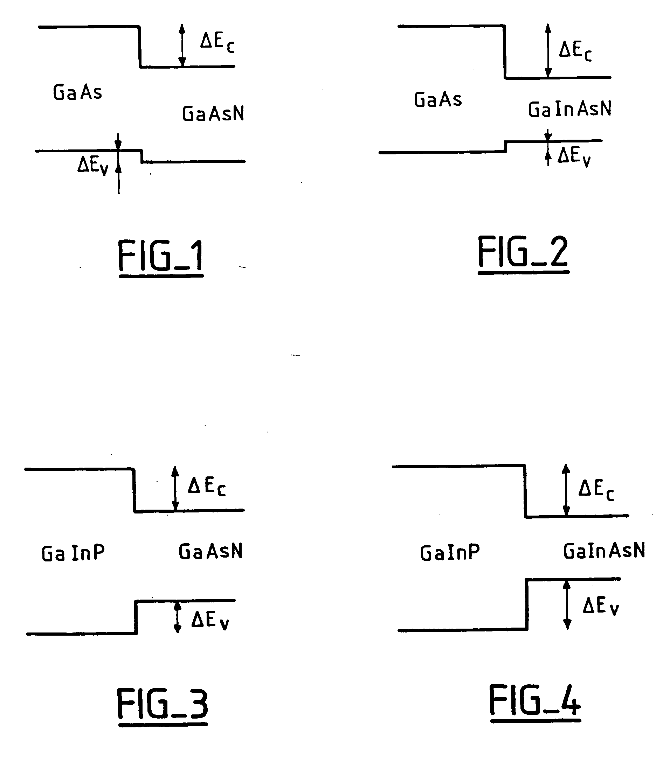

La figure 1 représente le schéma de bandes d'une hétérojonction GaAs/GaAsN.

Comme l'ont montré M. Kondow et coll. (Jpn. J.Appl. Phys., Vol. 35 (1996), 1273), la réduction de la largeur de la bande interdite de GaAsN par rapport à GaAs se fait principalement par la baisse de la bande de conduction. Ce phénomène crée à l'interface de l'hétérojonction GaAs/ GaAsN une forte discontinuité de la bande de conduction ΔEc et une faible discontinuité de la bande de valence.

Comme l'indique la figure 1, le bande de valence de GaAsN se situe en dessous de celle de GaAs. Compte tenu du fait que GaAsN en épitaxie avec GaAs est en désaccord de paramètre de maille avec ce dernier et que ce désaccord augmente avec la teneur en azote, il faut se limiter à des teneurs en azote de l'ordre de 5 % sous peine de faire apparaître des dislocations. Et en limitant à ces pourcentages d'azote dans GaAs, la largeur de la bande interdite de GaAsN sera de l'ordre d' 1 eV et par suite la discontinuité de la bande de conduction ΔEc de l'hétérojonction GaAs/ GaAsN sera au maximum de l'ordre d'une centaine de meV.

De ce fait, l'hétérojonction GaAs/GaAsN n'est pas adaptée à la réalisation de transistors HEMT. D'autre part, la bande de valence de GaAsN se situant en dessous de celle de GaAs, l'hétérojonction GaAs/GaAsN n'est pas non plus apte à la réalisation de transistors TBH performants.

Pour réaliser un transistor HEMT performant, il faut trouver une solution pour augmenter la discontinuité ΔEc. Cette solution, qui fait l'objet de la présente invention, consiste à utiliser l'alliage GaInAsN comme matériau à petite bande interdite. En effet, M. Kondow et coll. (référence précitée) ont montré que l'addition de l'indium à faible pourcentage dans GaAsN a pour effet de réduire la largeur de la bande interdite de GaAsN, de la même manière que l'addition de l'indium dans GaAs fait baisser la largeur de la bande interdite de GaInAs. Et cette baisse de largeur de la bande interdite GaInAsN s'effectue au niveau de la bande de conduction plus qu'au niveau de la bande de valence. Ceci donne pour la discontinuité ΔEc une valeur de 500 meV environ, qui est équivalente à celle d'un HEMT pseudomorphique réalisé avec l'hétérojonction AIGaAs/GaInAs bien connue de l'homme de l'art.

On peut augmenter encore plus la discontinuité ΔEc si l'on utilise l'hétérojonction AIGaAs/GaInAsN, car l'hétérojonction AIGaAs/GaAs présente aussi une discontinuité ΔEc qui s'ajoute à celle de GaAs/GaInAsN. Il est connu que ce caractère de transitivité de ΔEc est vérifié sur les composés III-V, et il en résulte que l'on peut obtenir pour l'hétérojonction AIGaAs/ GaInAsN des discontinuités dépassant 800 meV, valeur que l'on atteint difficilement avec les hétérojonctions sans azote. En effet, dans les hétérojonctions composées de matériaux à base d'arséniure, la plus grande discontinuité ΔEc est obtenue pour l'hétérojonction AIInAs/GaInAs où la teneur en indium est de 40 % environ. Or les composés riches en indium ont des paramètres de maille cristalline plus grands de 3 % par rapport à ceux de GaAs, et il est donc difficile de les faire croître par épitaxie sur un substrat GaAs sans créer de dislocations. L'homme de l'art peut cependant limiter la propagation des dislocations dans une couche tampon, laissant ainsi des couches actives vierges de toute dislocation (voir par exemple le WO-A-99/14809 (Picogiga) ou S. Bolaert et coll. (IEEE Electron Dev. Lett., 20, 123 (1999)). Ces procédés qui donnent lieu à la réalisation des HEMT métamorphiques peuvent aussi être utilisés pour épitaxier des matériaux GaInAsN à forte teneur en indium, d'environ 30 à 40 %. La discontinuité ΔEc des hétérojonctions AIInAs/GaInAsN avec 30 à 40 % d'indium dépasse alors 1 eV.

Une autre façon de faire, et qui fait l'objet de la présente invention, est de réaliser des hétérojonctions AIGaAs/GaInAsN où la teneur en indium est choisie de telle façon que la couche épitaxiale GaInAsN soit en désaccord de maille par rapport au substrat GaAs. Le transistor HEMT utilisant une telle hétérojonction est donc un HEMT pseudomorphique donc la discontinuité ΔEc dépasse 900 meV. Dans ce qui a été développé ci-dessus, l'invention concerne les transistors HEMT.

En ce qui concerne les transistors TBH, l'homme de l'art sait que l'hétérojonction qui constitue l'émetteur et la base du TBH doit présenter les caractéristiques suivantes :
- la bande interdite de la base doit être plus petite que celle de l'émetteur ;
- la discontinuité de la bande de valence doit être élevée ;
- la bande de valence de la base doit être située au dessus de celle de l'émetteur ;
- la discontinuité de la bande de conduction doit être faible afin de ne pas augmenter inutilement la tension d'ouverture V_{BE} du transistor.

Comme rappelé plus haut et visible sur la figure 1, l'hétérojonction GaAs/GaAsN ne satisfait pas ces conditions.

Par contre, l'hétérojonction GaInP/GaAsN y répond, à la condition d'avoir une grande discontinuité ΔEv (fig. 3). En effet, l'hétérojonction GaInP/ GaAs présente une discontinuité ΔEv de l'ordre de 400 meV et celle de GaAs/GaAsN une discontinuité ΔEv de -20 meV environ pour une teneur en indium de 5 %. La transitivité de la discontinuité de la bande de valence donne pour GaInP/GaAsN une discontinuité ΔEv de 380 meV environ, ce qui est suffisant pour réaliser un TBH performant. Du côté de la bande de conduction, la discontinuité ΔEc entre GaAs et GaAsN est de l'ordre de 50 meV et celle de GaInP et GaAs de 70 meV, ce qui donne pour l'hétérojonction GaInP/GaAsN une valeur de 120 meV, tout à fait convenable pour réaliser un transistor TBH performant. Cependant, GaAsN à 5 % de teneur en indium présente une largeur de bande interdite proche de GaAs, soit 1,35 eV environ. Pour les applications où il faut abaisser fortement la tension d'ouverture V_{BE}, il est avantageux de réduire encore plus la largeur de la bande interdite du matériau à petite bande interdite, et le matériau GaInAsN dont on a décrit les propriétés précédemment est tout à fait indiqué.

La figure 4 représente le schéma de bandes de l'hétérojonction GaInP/GaInAsN. La transitivité des discontinuités de bandes entre GaAs/ GaInAsN et GaInP/GaAs donne pour l'hétérojonction GaInP/GaInAsN une discontinuité ΔEv de 450 meV environ et une discontinuité ΔEc de 550 meV environ pour une teneur en indium et en azote de quelques pour cents chacun, afin d'avoir une largueur de bande interdite inférieure ou égale à 1 eV.

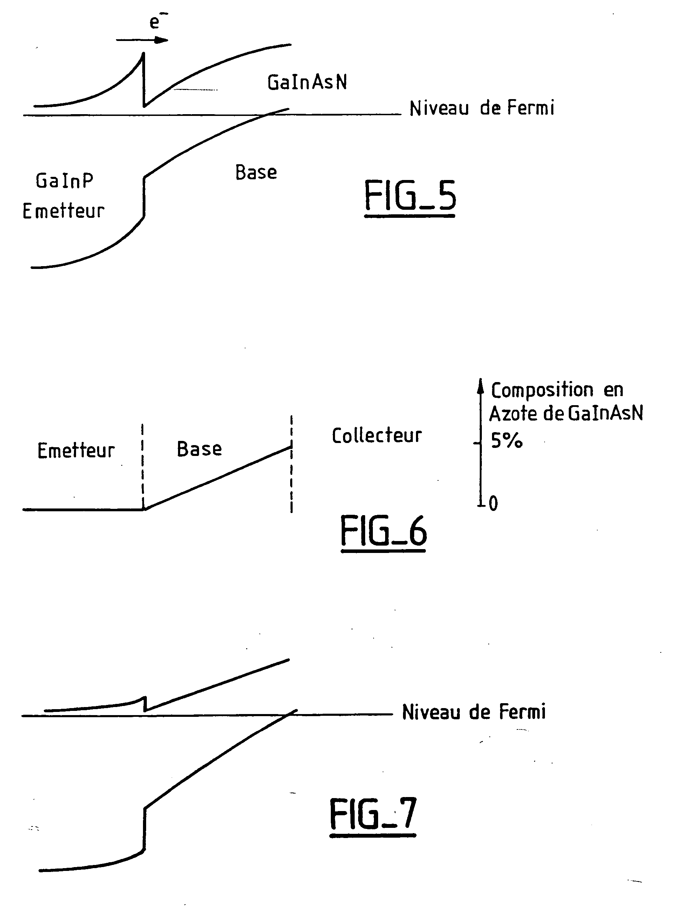

Dans cette configuration, la forte valeur de ΔEc est, par contre, défavorable : d'une part, parce que les électrons venant de l'émetteur GaInP vers la base GaInAsN ont une énergie trop élevée et risquent d'être injectés dans la bande L du matériau où la masse effective de l'électron est grande : d'autre part, parce qu'une grande valeur ΔEc crée à l'interface GaInP (type n)/GaInAsN (type p) un pic d'énergie créant ainsi une barrière d'énergie que les électrons injectés de l'émetteur vers la base doivent franchir (figure 5). Une telle situation accroît la tension d'ouverture V_{BE} du transistor.

Pour réduire la discontinuité ΔEc à l'interface de l'hétérojonction GaInP/ GaInAsN, on peut réaliser une base à composition graduelle où la teneur en azote est faible, voire nulle à l'interface et augmente graduellement quand on s'éloigne de l'interface comme l'indique la figure 6.

La figure 7 représente le schéma de bandes correspondant (on peut obtenir le même effet en utilisant une variation de composition en marches d'escalier). Dans le cas où l'on fait varier seulement la composition en azote sans changer la composition en indium, la jonction émetteur-base est une hétérojonction GaInP/GaInAs où la discontinuité de la bande de conduction ΔEc est de 100 meV environ pour une teneur en indium de 10 %, et est tout à fait adaptée à un TBH performant. Pour une teneur en indium de 10 % la bande interdite est de 1,3 eV environ. On peut réduire encore plus la bande interdite de GaInAs en utilisant Une composition en indium dépassant 25 % pour atteindre une largeur de bande interdite de 1 eV et une continuité ΔEc de l'ordre de 200 meV. Dans ces conditions, la couche de GaInAs est fortement contrainte comme dans le cas des HEMT pseudomorphiques: L'épaisseur de la couche de GaInAs est alors de l'ordre de 10 à 12 nm.

Les modes de réalisation autres que celui explicité dans les deux paragraphes ci-dessus ne correspondent pas à l'invention revendiqué mais sont utiles à sa compréhension.

La réduction de la discontinuité AEc est l'augmentation de la discontinuité ΔEv peuvent être avantageusement obtenues en utilisant pour la base un matériau contenant de l'antimoine, comme GaSbAs ou GaSbAsN. En effet, il est connu que le composé GaSb a sa bande de valence située juste au niveau d'énergie de celle de la bande de conduction de InAs (voir par exemple, L. Esaki, The Technology and Physics of Mo/ecu/ar Beam Epi-taxy, Plenum Press, 1985; p.171 ou S. Sakai (précité).

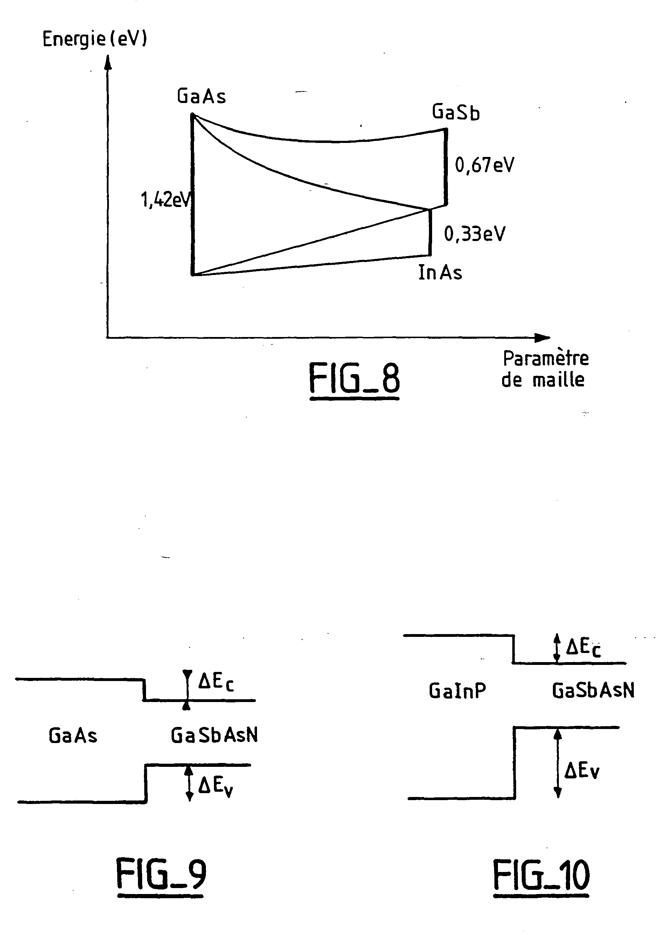

En utilisant la règle simple, qui s'applique bien pour les semi-conducteurs III-V, de l'alignement de la bande de valence aux dépends de la courbure de la bande de conduction, on obtient la configuration représentée dans la figure 8.

Sur cette figure, on a représenté schématiquement la position des bandes de valence et de conduction des trois matériaux GaAs, GaSb et InAs, ainsi que celle des alliages binaires GaInAs et GaSbAs. On observe que les alliages GaSbAs ont leur bande de valence située au-dessus de celle des alliages GaInAs. Il en est de même pour leur bande de conduction. On peut déduire de la figure 8 que l'hétérojonction GaAs/GaSbAs présente une plus faible ΔEc et une plus forte ΔEv que l'hétérojonction GaAs/GaInAs. Il est donc plus avantageux d'utiliser l'hétérojonction GaAs/ GaSbAs pour réaliser des transistors TBH.

Cependant, GaSbAs présente un écart de paramètre de maille par rapport à GaAs et l'on ne pourra donc pas avoir une teneur en indium suffisamment forte et/ou une épaisseur suffisamment forte pour réaliser une base de transistor. La substitution d'une faible concentration d'azote pour former le quaternaire GaSbAsN permet de réajuster le paramètre de maille comme dans le cas de GaInAsN et comme dans le cas de GaInAsN, une faible teneur en azote dans ce quaternaire permet de réduire en même temps la largeur de la bande interdite jusqu'à des valeurs proches de 0,8 eV, ce qui favorise la réduction de la tension V_{BE}.

Comme l'addition d'azote déplace la discontinuité ΔEc vers les valeurs élevées, le schéma de bande de l'hétérojonction GaAs/GaSbAsN a l'allure représentée sur la figure 9. La discontinuité des bandes de cette hétérojonction n'est pas bien connue mais on peut estimer que, pour une teneur en azote de 2 à 3 % et une teneur en antimoine de 10 % environ, ΔEc est de l'ordre de 50 meV et ΔEv de l'ordre de 350 à 400 meV. Ces valeurs sont très comparables à celles de l'hétérojonction GaInP/GaAs, qui est connue pour être très bien adaptée à la réalisation de TBH performants.

L'association GaInP/GaSbAsN donne, par transitivité des bandes, une discontinuité ΔEc de 100 meV et une discontinuité ΔEv de 800 meV environ (figure 10).

Dans ce qui a été développé ci-dessus, on peut noter que l'addition d'indium dans GaAsN a pour effet de créer une forte discontinuité de la bande de conduction ΔEc alors que l'addition de l'antimoine, une faible discontinuité ΔEc. Et l'effet est inverse sur la discontinuité de la bande de valence ΔEv. Il est donc possible d'ajuster les discontinuités ΔEc et ΔEv en utilisant les composés quinquénaires GaInSbAsN.

## Revendications

1. Transistor à hétérojonction, comprenant des matériaux semi-conducteurs III-V avec un matériau à grande bande interdite et un matériau à petite bande interdite,
- le matériau à petite bande interdite étant un composé III-V contenant le gallium comme l'un des éléments III et à la fois l'arsenic et l'azote comme éléments V,
- le matériau à petite bande interdite comportant au moins un quatrième élément, III ou V,
**caractérisé en ce que** :
- ledit transistor est un transistor bipolaire à hétérojonction, dans lequel le matériau à petite bande interdite forme la base du transistor et le matériau à grande bande interdite forme l'émetteur du transistor,
- le quatrième élément est l'indium, substitué au gallium en une fraction d'au plus 10 %,
- le matériau à grande bande interdite est GaInP avec une teneur en indium de 50%,
- le matériau formant la base du transistor présente une composition en azote graduée ou en marches d'escalier, la teneur en azote étant nulle à l'interface de l'hétérojonction émetteur-base et allant croissant en allant vers la base,
- la teneur en azote du matériau à petite bande interdite est inférieure à 5%.

## Claims

1. A heterojunction transistor that includes type III-V semiconductor materials, with a large band-gap material and a small band-gap material, in which:
- the small band-gap material is an III-V compound containing gallium as one of the III elements and both arsenic and nitrogen as the V elements,
- the small band-gap material includes at least one fourth element, either III or V,
**characterised in that**
- said transistor is a heterojunction bipolar transistor, in which the small band-gap material forms the basis of the transistor, and the large band-gap material forms the emitter of the transistor,
- the fourth element is indium, substituted for gallium in a proportion of no more than 10%,
- the large band-gap material is GaInP, with an indium content of 50%;
- the material forming the base of the transistor has a nitrogen composition that is graduated or stair-step in form, with the nitrogen content being zero at the interface of the emitter-base heterojunction and growing as it approaches the base,
- the nitrogen content of the small band-gap material is less than 5%.

## Patentansprüche

1. Heteroübergangstransistor, Halbleitermaterialien III-V mit einem Material mit großem verbotenem Band und einem Material mit kleinem verbotenem Band umfassend,
- wobei das Material mit kleinem verbotenem Band eine Verbindung III-V ist, die Gallium als eines der Elemente III et gleichzeitig Arsen und Stickstoff als Elemente V enthält,
- wobei das Material mit kleinem verbotenem Band mindestens ein viertes Element, III oder V, aufweist,
**dadurch gekennzeichnet, dass**:
- der Transistor ein bipolarer Heteroübergangstransistor ist, in welchem das Material mit kleinem verbotenem Band die Basis des Transistors und das Material mit großem verbotenem Band den Emitter des Transistors bildet,
- das vierte Element das Indium ist, das das Gallium in einem Anteil von höchstens 10 % ersetzt,
- das Material mit großem verbotenem Band GaInP mit einem Indiumgehalt von 50 % ist,
- das Material, das die Basis des Transistors bildet, eine gestaffelte oder abgestufte Stickstoffverbindung aufweist, wobei der Stickstoffgehalt an der Schnittstelle des Heteroübergangs Emitter-Basis Null ist und in Richtung Basis ansteigt,
- der Stickstoffgehalt des Materials mit kleinem verbotenem Band kleiner als 5 % ist.
